# EUROPÄISCHE PATENTSCHRIFT

(11) **EP 4 157 789 B1**
(45) Veröffentlichungstag und Bekanntmachung des Hinweises auf die Patenterteilung: **02.12.2026**
(21) Anmeldenummer: 21730106.8
(22) Anmeldetag: 19.05.2021
(51) Int. Cl.: B81C 1/00, B01L 3/00

(54) **VERFAHREN UND STEUERGERÄT ZUM HERSTELLEN EINES TRÄGERELEMENTS ZUM AUFNEHMEN EINER PROBENFLÜSSIGKEIT, TRÄGERELEMENT, TRÄGERMODUL UND VERFAHREN ZUM VERWENDEN EINES TRÄGERELEMENTS**
METHOD AND CONTROL UNIT FOR PRODUCING A CARRIER ELEMENT FOR RECEIVING A SAMPLE LIQUID, CARRIER ELEMENT, CARRIER MODULE, AND METHOD FOR USING A CARRIER ELEMENT
PROCÉDÉ ET APPAREIL DE COMMANDE POUR LA RÉALISATION D'UN ÉLÉMENT DE SUPPORT DESTINÉ À RECEVOIR UN ÉCHANTILLON DE LIQUIDE, ÉLÉMENT DE SUPPORT, MODULE DE SUPPORT ET PROCÉDÉ POUR UTILISER UN ÉLÉMENT DE SUPPORT

(30) Priorität: 28.05.2020 DE 102020206696
(43) Veröffentlichungstag der Anmeldung: 05.04.2023
(73) Patentinhaber: Robert Bosch GmbH, 70442 Stuttgart (DE)
(72) Erfinder: LAERMER, Franz, 71263 Weil Der Stadt (DE); PODBIEL, Daniel Sebastian, 71277 Rutesheim (DE)
(86) Internationale Anmeldenummer: PCT/EP2021/063232
(87) Internationale Veröffentlichungsnummer: WO 2021/239528

(56) Entgegenhaltungen:
- DE-C1- 4 241 045
- FR-A1- 2 879 483

## Beschreibung

### Stand der Technik

Die Erfindung geht von einem Verfahren und einem Steuergerät zum Herstellen eines Trägerelements zum Aufnehmen einer Probenflüssigkeit, einem Trägerelement, einem Trägermodul und einem Verfahren zum Verwenden eines Trägerelements nach Gattung der unabhängigen Ansprüche aus. Gegenstand der vorliegenden Erfindung ist auch ein Computerprogramm.

Mikrofluidische Analysesysteme, sogenannte Lab-on-Chips (LoC), ermöglichen eine vollautomatisierte molekulardiagnostische Analyse von Patientenproben an einem so genannten Point-of-Care. Die Analyse der Probe erfolgt dabei in einer LoC-Kartusche, welche als Einwegteil vorgesehen ist.

Die Druckschrift FR 2 879 483 A1 offenbart ein Verfahren zur Erhöhung der Hydophobizität einer äußeren Beschichtung einer analytischen Vorrichtung wie beispielsweise eines Biochips, eine solche Vorrichtung und ein Verfahren zu ihrer Herstellung. Dabei wird eine hydrophile Schicht mit Ausnehmungen mit einem organischen Plasma, beispielsweise ein Fluorkohlenstoff-Plasma oder ein Siloxan-Plasma, behandelt, wodurch ein hydrophober Film abgeschieden wird.

Die Druckschrift DE 42 41 045 C1 offenbart ein Verfahren zum anisotropen Ätzen von Silicium.

### Offenbarung der Erfindung

Vor diesem Hintergrund werden mit dem hier vorgestellten Ansatz ein verbessertes Verfahren, weiterhin ein verbessertes Steuergerät, das dieses Verfahren verwendet, ein verbessertes Trägerelement, ein verbessertes Trägermodul und ein verbessertes Verfahren zum Verwenden eines Trägerelements, sowie schließlich ein entsprechendes Computerprogramm gemäß den Hauptansprüchen vorgestellt. Durch die in den abhängigen Ansprüchen aufgeführten Maßnahmen sind vorteilhafte Weiterbildungen und Verbesserungen der im unabhängigen Anspruch angegebenen Vorrichtung möglich.

Durch den hier vorgestellten Ansatz wird eine Möglichkeit geschaffen, um beispielsweise ein Trägerelement mit einer vorteilhaften Oberflächenbeschaffenheit kostengünstig herzustellen. Ferner wird hierdurch eine verbesserte Analyse einer Probenflüssigkeit ermöglicht.

Es wird ein erfindungsgemäßes Verfahren zum Herstellen eines Trägerelements zum Aufnehmen einer Probenflüssigkeit mit einer auf dem Trägersubstrat angeordneten Polymerschicht mit einer hydrophoben Oberflächenbeschaffenheit vorgestellt, das einen Schritt des Beschichtens, einen Schritt des Belichtens und Entwickelns und einen Schritt des Fluorierens umfasst. Im Schritt des Beschichtens wird ein Trägersubstrat mit einer lichtsensitiven Polymerschicht beschichtet, um ein beschichtetes Trägersubstrat zu erhalten. Dabei weist das Trägersubstrat eine hydrophile Oberflächenbeschaffenheit auf. Im Schritt des Belichtens und Entwickelns wird das beschichtete Trägersubstrat belichtet und entwickelt, um eine strukturierte Polymerschicht zu erhalten. Im Schritt des Fluorierens wird die auf dem Trägersubstrat angeordnete strukturierte Polymerschicht fluoriert, um das Trägerelement zum Aufnehmen der Probenflüssigkeit herzustellen. Dabei erhält die strukturierte Polymerschicht durch den Schritt des Fluorierens insbesondere eine hydrophobe Oberflächenbeschaffenheit.

Das Trägerelement kann beispielsweise in Form eines Lab-on-Chips realisiert sein, das ausgebildet ist, um eine Probenflüssigkeit aufzunehmen. Die Probenflüssigkeit kann beispielsweise eine Körperflüssigkeit, ein Sekret oder dergleichen als Patientenprobe sein, die beispielsweise analysiert werden soll. Das Trägersubstrat kann beispielsweise als Basismaterial realisiert sein, das bestimmte gewünschte Eigenschaften aufweist und weitere Komponenten des Trägerelementes trägt oder aufnimmt. Die lichtsensitive Polymerschicht kann beispielsweise als eine Kunststofflage oder -schicht wie beispielsweise ein Fotolack ausgeformt sein. Dabei kann beispielsweise diese Polymerschicht zunächst in flüssiger Form auf das Trägersubstrat aufgebracht werden und anschließend, beispielsweise durch ein Temperieren, ausgehärtet werden. Im Schritt des Belichtens kann beispielsweise das beschichtete Trägersubstrat, also hier beispielsweise speziell die Polymerschicht, mit Licht belichtet werden, das beispielsweise eine elektromagnetische Strahlung aufweist, die auch Wellenlängen aufweisen kann, die über einen Wellenlängenbereich des sichtbaren Lichts hinausgehen. Eine solche Strahlung kann beispielsweise Ultraviolett-Strahlung (UV) oder Röntgenstrahlung umfassen. Durch das Belichten und Entwickeln können vorteilhafterweise belichtete Bereiche der Polymerschicht von dem beschichteten Trägersubstrat gezielt in ihrer Löslichkeit in einem Lösungsmittel verändert und anschließend entfernt werden, sodass vorteilhafterweise die strukturierte Polymerschicht erhalten wird. Vorteilhafterweise wird das Trägersubstrat und zusätzlich oder alternativ die Polymerschicht oder eine Oberfläche der Polymerschicht im Schritt des Fluorierens mit beispielsweise einem fluorhaltigen Material, Stoff, Plasma und zusätzlich oder alternativ einer Lösung in Kontakt gebracht. Unter einem Fluorieren kann somit ein In-Kontakt-Bringen beispielsweise einer Oberfläche der Polymerschicht mit einem fluorhaltigen Material, Stoff, Plasma und zusätzlich oder alternativ einer Lösung verstanden werden. Vorteilhafterweise wird dadurch die Oberflächenbeschaffenheit der strukturierten Polymerschicht hydrophober realisiert als sie es zuvor war. Insgesamt kann vorteilhafterweise eine lokale Benetzung des Trägersubstrats mit der Probenflüssigkeit ermöglicht werden, da das Trägersubstrat in Kombination mit der strukturierten Polymerschicht hydrophobe Bereiche und hydrophile Bereiche aufweisen kann.

Gemäß einer Ausführungsform kann im Schritt des Beschichtens das Trägersubstrat beschichtet werden, welches zumindest teilweise aus einem Halbleitermaterial, insbesondere aus einem siliziumhaltigen Material ausgeformt sein kann. Speziell kann hierbei eine Oberfläche des Halbleitermaterials mit der lichtsensitiven Polymerschicht beschichtet sein. Vorteilhafterweise kann dadurch die Polymerschicht des beschichteten Trägersubstrats eine hydrophobe Oberflächenbeschaffenheit aufweisen.

Das Verfahren kann einen Schritt des Strukturierens des Trägersubstrats umfassen, um die zumindest eine Ausnehmung in dem Trägersubstrat zu erhalten.

Vorteilhafterweise kann das Trägersubstrat beispielsweise geätzt werden, um die zumindest eine Ausnehmung zu erhalten. Die Ausnehmung kann beispielsweise auch als Volumenstruktur bezeichnet werden. Auf diese Weise können vorteilhaft und technisch einfach Fluidkanäle oder -kammern in der Ausnehmung zur Analyse der Probenflüssigkeit ausgebildet sein.

Gemäß einer Ausführungsform kann in dem Schritt des Strukturierens eine Passivierungsschicht auf zumindest einer Seitenwand der zumindest einen Ausnehmung erzeugt werden. Zusätzlich kann im Schritt des Fluorierens die an zumindest einer Seitenwand der Ausnehmung angeordnete Passivierungsschicht zumindest teilweise entfernt werden. Vorteilhafterweise kann eine Lage beispielsweise die Seitenwandpolymere, welche im Schritt des Fluorierens beispielsweise zumindest teilweise entfernt werden, an der Seitenwand der Ausnehmung ausformen. Dadurch kann erreicht werden, dass zumindest eine Fläche innerhalb der Ausnehmung, die beispielsweise auch als Mikrokavität bezeichnet werden kann, entsprechend der Erfindung hydrophil ausgeformt ist.

Im Schritt des Beschichtens kann gemäß einer Ausführungsform als Trägersubstrat ein Substrat mit einer Oxidschicht und zusätzlich oder alternativ mit einer Haftvermittlerschicht beschichtetes Trägersubstrat verwendet werden. Der Haftvermittler kann beispielsweise als ein Alkyl-Trichlorsilan oder als ein Hexamethyldisilazan (HMDS) ausgeformt sein, durch den vorteilhafterweise ein Ablösen der Polymerschicht von dem Trägersubstrat verhindert werden kann. Das bedeutet, dass der Haftvermittler insbesondere für den Fall, dass das Substrat eine Oxidschicht aufweist, beispielsweise als Haftmittel zwischen dem Trägersubstrat und der Polymerschicht ausgeformt sein kann.

Ferner kann das Verfahren einen Schritt des Aufbringens einer weiteren lichtsensitiven Polymerschicht und einen Schritt des weiteren Belichtens und Entwickelns der weiteren Polymerschicht umfassen, um eine weitere strukturierte Polymerschicht zu erhalten. Die weitere Polymerschicht kann vorteilhafterweise aus dem gleichen Material ausgeformt sein wie die Polymerschicht. Hierbei kann die (erste) Polymerschicht verwendet werden, um damit eine Oxid-Schicht auf dem Substrat zu strukturieren. Hiernach wird beispielsweise die (erste) Polymerschicht entfernt und anschließend wird die weitere Polymerschicht auf das Substrat mit der strukturierten Oxid-Schicht aufgebracht. Die Oxid-Schicht und die weitere Polymerschicht dienen dann beispielsweise gemeinsam als Resist für einen Ätzschritt zur Volumenstrukturierung des Substrats. Die weitere Polymerschicht kann dann beispielsweise fluoriert werden und dient damit zur Bildung einer Schicht mit einer hydrophoben Oberflächenbeschaffenheit. Die räumliche Ausgestaltung der Volumenstrukturierung, welche ebenfalls durch die Oxid-Schicht (d. h. die erste Polymerschicht) definiert wurde, kann damit in vorteilhafter Weise teilweise unabhängig von der Erzeugung und der räumlichen Ausgestaltung der hydrophoben Schicht erfolgen. Auf diese Weise kann eine Strukturierung der weiteren Polymerschicht vorgenommen werden, die sich von einer Art der Strukturierung der Polymerschicht unterscheidet, sodass ein Grad der Flexibilisierung bei der Strukturierung erhöht werden kann.

Gemäß einer Ausführungsform kann das Verfahren einen weiteren Schritt des Strukturierens nach dem weiteren Belichten und Entwickeln umfassen, um zumindest eine weitere Ausnehmung in dem Trägersubstrat zu erhalten. Dadurch kann vorteilhafterweise eine Mikrokavität erzeugt werden.

In einem Schritt des Abscheidens kann eine Schicht nach dem Schritt des Fluorierens abgeschieden werden, um eine Oberfläche des Trägersubstrats zu verändern und zusätzlich oder alternativ abzudecken. Dadurch kann erzielt werden, dass die Ausnehmung sowie, erfindungsgemäß, ihre Seitenwand durch die abgeschiedene Schicht hydrophil und die Oberfläche der Polymerschicht dagegen hydrophob ausgeformt ist. Dadurch kann vorteilhafterweise ein Kapillareffekt und zusätzlich oder alternativ ein versehentliches Mischen der in mehrere Ausnehmungen eingebrachten Probeflüssigkeit vermieden werden.

Dieses Verfahren kann beispielsweise in Software oder Hardware oder in einer Mischform aus Software und Hardware beispielsweise in einem Steuergerät implementiert sein.

Der hier vorgestellte Ansatz schafft ferner eine erfindungsgemäße Vorrichtung, die ausgebildet ist, um die Schritte erfindungsgemäßer Verfahren in entsprechenden Einrichtungen durchzuführen, anzusteuern bzw. umzusetzen. Auch durch diese Ausführungsvariante der Erfindung in Form eines Steuergeräts kann die der Erfindung zugrundeliegende Aufgabe schnell und effizient gelöst werden.

Hierzu kann die Vorrichtung zumindest eine Recheneinheit zum Verarbeiten von Signalen oder Daten, zumindest eine Speichereinheit zum Speichern von Signalen oder Daten, zumindest eine Schnittstelle zu einem Sensor oder einem Aktor zum Einlesen von Sensorsignalen von dem Sensor oder zum Ausgeben von Steuersignalen an den Aktor und/oder zumindest eine Kommunikationsschnittstelle zum Einlesen oder Ausgeben von Daten aufweisen, die in ein Kommunikationsprotokoll eingebettet sind. Die Recheneinheit kann beispielsweise ein Signalprozessor, ein Mikrocontroller oder dergleichen sein, wobei die Speichereinheit ein Flash-Speicher, ein EEPROM oder eine magnetische Speichereinheit sein kann. Die Kommunikationsschnittstelle kann ausgebildet sein, um Daten drahtlos und/oder leitungsgebunden einzulesen oder auszugeben, wobei eine Kommunikationsschnittstelle, die leitungsgebundene Daten einlesen oder ausgeben kann, diese Daten beispielsweise elektrisch oder optisch aus einer entsprechenden Datenübertragungsleitung einlesen oder in eine entsprechende Datenübertragungsleitung ausgeben kann.

Unter einer Vorrichtung kann vorliegend ein elektrisches Gerät verstanden werden, das Sensorsignale verarbeitet und in Abhängigkeit davon Steuer- und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen des Steuergeräts beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

In einer vorteilhaften Ausgestaltung erfolgt durch die Vorrichtung eine Steuerung eines Verfahrens zum Herstellen eines Trägerelements zum Aufnehmen einer Probenflüssigkeit. Hierzu kann die Vorrichtung beispielsweise auf Sensorsignale wie ein Beschichtsignal zum Beschichten eines Trägersubstrats mit einer lichtsensitiven Polymerschicht, ein Belichtsignal zum Belichten und Entwickeln des beschichteten Trägersubstrats und ein Fluorsignal zum Fluorieren der auf dem Trägersubstrat angeordneten strukturierten Polymerschicht zugreifen. Die Ansteuerung erfolgt über Aktoren wie eine Bereitstelleinheit, die ausgebildet ist, um ein Beschichten, ein Belichten und Fluorieren bereitzustellen. Die einzelnen Prozessschritte können hierbei nach dem Stand der Technik in verschiedenen, speziell dafür ausgebildeten Anlagen wie einer Lackschleuder (Beschichten), einem Maskenbelichter (Belichten) und einer Niederdruck-Plasmaanlage (Fluorieren) ausgeführt werden. Denkbar wäre auch, dass die Substrate/Wafer während des Verfahrens durch Waferhandling-Vorrichtungen (teilweise) automatisiert zwischen den verschiedenen Anlagen transferiert werden.

Von Vorteil ist auch ein erfindungsgemäßes Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Ferner wird ein erfindungsgemäßes Trägerelement zum Aufnehmen einer Probenflüssigkeit vorgestellt, wobei das Trägerelement ein Trägersubstrat mit einer hydrophilen Oberflächenbeschichtung an einer Seitenwand von zumindest einer Ausnehmung in dem Trägersubstrat und eine auf dem Trägersubstrat angeordnete Polymerschicht mit einer hydrophoben Oberflächenbeschaffenheit aufweist.

Das Trägerelement kann beispielsweise als ein Lab-on-Chip (LoC) oder als ein Mikroarray bezeichnet werden. Das Trägerelement ist beispielsweise für ein Trägermodul verwendbar. Vorteilhafterweise kann das Trägerelement verwendet werden, um beispielsweise die Probeflüssigkeit zu analysieren, die beispielsweise aus einer zu untersuchenden Körperflüssigkeit eines Patienten gewonnen wurde.

Weiterhin wird ein Trägermodul vorgestellt, das ein Trägerelement in einer zuvor genannten Variante zum Aufnehmen einer Probenflüssigkeit und ein mit dem Trägerelement verbindbares oder verbundenes Deckelelement aufweist, das ausgebildet ist, um die Probenflüssigkeit auf das Trägerelement aufzubringen. Das Trägermodul kann vorteilhafterweise als eine Einmal-Kartusche realisiert sein.

Außerdem wird ein erfindungsgemäßes Verfahren zum Verwenden eines Trägerelements in der zuvor genannten Variante mit Deckelelement vorgestellt, wobei bei dem Verwenden des Trägerelements eine Probenflüssigkeit in Kontakt mit der fluorierten strukturierten Polymerschicht gebracht wird, und zusätzlich oder alternativ wobei die Probenflüssigkeit mit einer Oberfläche des Trägersubstrats in Kontakt gebracht wird.

Vorteilhafterweise kann die Probenflüssigkeit von der Ausnehmung des Trägerelements aufgenommen werden.

Ausführungsbeispiele des hier vorgestellten Ansatzes sind in den Zeichnungen dargestellt und in der nachfolgenden Beschreibung näher erläutert. Es zeigt:
Fig. 1 ein Ablaufdiagramm eines Verfahrens zum Herstellen eines Trägerelements zum Aufnehmen einer Probenflüssigkeit gemäß einem Ausführungsbeispiel;
Fig. 2 ein Ablaufdiagramm eines Ausführungsbeispiels eines Verfahrens zum Herstellen eines Trägerelements zum Aufnehmen einer Probenflüssigkeit;
Fig. 3 eine schematische Darstellung verschiedener Zwischenprodukte eines Trägerelements gemäß einem Ausführungsbeispiel während eines Verfahrens zum Herstellen des Trägerelements zum Aufnehmen einer Probenflüssigkeit;
Fig. 4 eine schematische Querschnittsdarstellung eines Trägerelements gemäß einem Ausführungsbeispiel;
Fig. 5 eine schematische Darstellung verschiedener Zwischenprodukte eines Trägerelements gemäß einem Ausführungsbeispiel während eines Verfahrens zum Herstellen des Trägerelements zum Aufnehmen einer Probenflüssigkeit;
Fig. 6 eine schematische Querschnittsdarstellung eines Trägerelements gemäß einem Ausführungsbeispiel;
Fig. 7 eine schematische Querschnittsdarstellung eines Trägermoduls gemäß einem Ausführungsbeispiel;
Fig. 8 ein Ablaufdiagramm eines Verfahrens zum Verwenden eines Trägerelements gemäß einem Ausführungsbeispiel; und
Fig. 9 ein Blockschaltbild einer Vorrichtung gemäß einem Ausführungsbeispiel.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

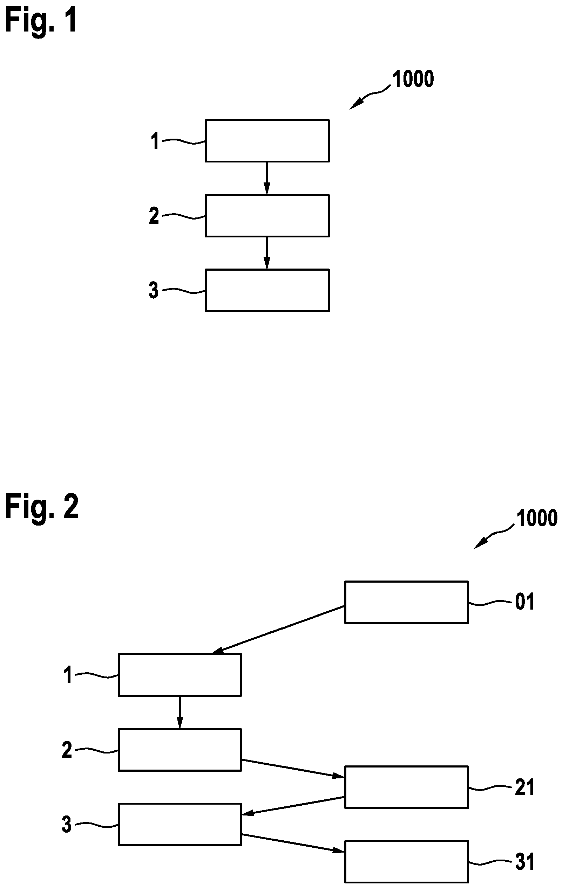

Fig. 1 zeigt ein Ablaufdiagramm eines Verfahrens 1000 zum Herstellen eines Trägerelements 100 zum Aufnehmen einer Probenflüssigkeit gemäß einem Ausführungsbeispiel. Das durch das Verfahren 1000 herzustellende und/oder hergestellte Trägerelement ist beispielsweise als ein Mikroarray ausgeformt, um die Probeflüssigkeit aufzunehmen. Die Probenflüssigkeit ist beispielsweise als eine wässrige Lösung realisiert, die insbesondere aus einer biologischen Substanz gewonnen wird, die beispielsweise humanen Ursprungs ist. Die Substanz zur Gewinnung der Probenflüssigkeit ist beispielsweise als eine Körperflüssigkeit, ein Abstrich, ein Sekret, Sputum, eine Gewebeprobe realisiert oder wird aus einer Vorrichtung mit angebundenem Probenmaterial gewonnen. In der Probenflüssigkeit befinden sich insbesondere Spezies von medizinischer, klinischer, diagnostischer oder therapeutischer Relevanz, wie beispielsweise Bakterien, Viren, Zellen, zirkulierende Tumorzellen, zellfreie DNA, Proteine sowie andere Biomarker oder Bestandteile aus den genannten Objekten. Insbesondere handelt es sich bei der Probenflüssigkeit gemäß diesem Ausführungsbeispiel um einen Mastermix für die Durchführung einer Amplifikationsreaktion wie beispielsweise einer Polymerase-Kettenreaktion oder einer isothermalen Amplifikationsreaktion.

Das Trägerelement ist dabei beispielsweise ausgebildet, um in Verbindung mit einem Trägermodul verwendet zu werden.

Das Verfahren 1000 umfasst dabei einen Schritt 1 des Beschichtens eines Trägersubstrats mit einer lichtsensitiven Polymerschicht, die beispielsweise als ein Fotolack ausgeformt ist. Das Trägersubstrat weist dabei eine hydrophile Oberflächenbeschaffenheit auf. In einem Schritt 2 des Belichtens und Entwickelns wird das Trägersubstrat belichtet und entwickelt, um eine strukturierte Polymerschicht zu erhalten. Dazu ist beispielsweise elektromagnetische Strahlung verwendbar, die auch über einen sichtbaren Bereich hinausgeht. Das Verfahren 1000 umfasst weiterhin einen Schritt 3 des Fluorierens der auf dem Trägersubstrat angeordneten strukturierten Polymerschicht, beispielsweise durch in Kontaktbringen mit einem Plasma mit einem fluorhaltigen Stoff, um das Trägerelement zum Aufnehmen der Probenflüssigkeit herzustellen. Dabei erhält die strukturierte Polymerschicht eine hydrophobe Oberflächenbeschaffenheit. Gemäß diesem Ausführungsbeispiel ist das Trägersubstrat aus einem Halbleitermaterial, insbesondere aus einem siliziumhaltigen Material ausgeformt. Das Trägersubstrat ist außerdem beispielsweise als ein Substrat mit einer Oxidschicht und/oder mit einer Haftvermittlerschicht ausgeformt.

Allgemein ermöglichen mikrofluidische Analysesysteme, die beispielsweise als Lab-on-Chips (LoCs) bezeichnet werden, eine vollautomatisierte molekulardiagnostische Analyse von beispielsweise Patientenproben am Point-of-Care. Die Analyse der Probenflüssigkeit erfolgt dabei in einer LoC-Kartusche, welche als Einwegteil vorgesehen ist. Für eine kostengünstige Herstellung von LoC-Kartuschen eignen sich insbesondere Polymere. Hochdurchsatzverfahren, wie beispielsweise Spritzgießen oder Laserdurchstrahlschweißen, erlauben eine kosteneffiziente Massenfertigung. Derartig hergestellte LoC-Kartuschen weisen jedoch fertigungstechnisch und materialbedingt Limitationen oder nachteilige Eigenschaften auf. Die erzielbaren Strukturgrößen sind demnach herstellungstechnisch begrenzt, die Wärmeleitfähigkeit von Polymeren ist nur gering und es liegt keine intrinsische elektrische Funktionalisierbarkeit vor, wie beispielsweise bei Halbleitern, die eine Dotierung erlauben. Darüber hinaus weisen die zumeist unpolaren Polymeroberflächen eine eher hydrophobe Beschaffenheit und damit eine schlechte Benetzbarkeit für insbesondere wässrige Lösungen auf. Um diese Limitationen zu überwinden und erweiterte mikrofluidische Funktionalitäten in einer LoC-Kartusche bereitstellen zu können, eignet sich eine Integration von Komponenten aus anderen Materialien, welche vorteilhafte Eigenschaften aufweisen. Insbesondere erscheint eine Integration von mikrostrukturierten Silizium-Komponenten von Vorteil. Das Material Silizium weist eine sehr gute Mikrostrukturierbarkeit, eine hohe thermische Leitfähigkeit sowie halbleitende Eigenschaften auf. Jedoch ist zur Bereitstellung eines mikrofluidischen Bauteils, das hier als Trägerelement bezeichnet ist, mit einer gewünschten mikrofluidischen Funktionalität meist zusätzlich eine kontrollierte Anpassung der Benetzungseigenschaften der Oberfläche von Vorteil.

Vor diesem Hintergrund wird daher das Verfahren 1000 vorgestellt, welches eine lokale Anpassung der Benetzungseigenschaften des Trägersubstrats, insbesondere von Silizium und vor allem auf Grundlage einer fotolithographischen Technik erlaubt. Darüber hinaus wird durch das Verfahren 1000 zusätzlich zu der Anpassung der Benetzungseigenschaften eine Mikrostrukturierung des Trägersubstrats unter Verwendung eines einzelnen fotolithographischen Prozessschrittes ermöglicht. Auf diese Weise ist eine besonders kostengünstige Herstellung dreidimensionaler Trägerelemente mit lokal angepassten Benetzungseigenschaften der Oberfläche möglich. Ein durch den hier vorgestellten Ansatz hergestelltes Trägerelement ist ferner als Bestandteil eines Trägermoduls einsetzbar, das eine Verwendung des Trägerelements beispielsweise in Kombination mit einer polymerbasierten LoC-Kartusche erlaubt.

Daher wird hier ein Verfahren 1000 vorgestellt, welches die fotolithographische Herstellung mikrofluidischer Bauteile und/oder Komponenten- insbesondere auf Grundlage von Silizium - erlaubt, die über ein lokal angepasstes Benetzungsverhalten für Flüssigkeiten, insbesondere für wässrige Lösungen, verfügen. In einer Weiterführung des Verfahrens 1000 erfolgt neben einer lokalen Anpassung des Benetzungsverhaltens der Oberfläche auch eine Volumenstrukturierung des Trägersubstrates. Das Verfahren 1000 zeichnet sich beispielsweise durch die Erzeugung einer fluorierten Oberfläche auf, insbesondere der fluorierten mikrostrukturierten Polymerschicht, welche eine hydrophobe, das bedeutet wasserabweisende Oberflächenbeschaffenheit im Unterschied zu der gegebenenfalls geeignet modifizierten Substratoberfläche aufweist, welche vorzugsweise eine hydrophile Beschaffenheit aufweist.

In anderen Worten ausgedrückt wird durch das Verfahren 1000 zur Herstellung eines mikrofluidischen Bauteils, das auch als Trägerelement bezeichnet wird, das Trägerelement hergestellt, das lokal angepasste Benetzungseigenschaften einer Oberfläche des Trägersubstrats aufweist. Im Schritt 1 des Beschichtens wird die lichtsensitive Polymerschicht auf das Trägersubstrat, wie beispielsweise Silizium, beispielsweise durch Aufschleudern auf das Trägersubstrat aufgebracht und anschließend erhitzt, das auch als "Backen" bezeichnet wird, um Lösemittelreste zu entfernen. Im Schritt 2 des Belichtens und Entwickelns wird die Polymerschicht beispielsweise mittels einer Maske lokal belichtet, welche über die zu erzeugenden Strukturen oder deren Negativ verfügt, oder unter Verwendung eines direktschreibenden Verfahrens belichtet, beispielsweise durch Laserdirektstrahlschreiben. Die belichtete Polymerschicht wird beispielsweise in einem geeigneten Lösemittel entwickelt, sodass anschließend eine strukturierte Polymerschicht auf der Substratoberfläche vorliegt. Im Schritt 3 des Fluorierens wird die strukturierte Polymerschicht fluoriert, um deren Oberfläche besonders hydrophob, das bedeutet abweisend für wässrige Lösungen, beispielsweise durch Behandlung in einem Plasma mit Anteilen von einer fluorhaltigen Verbindung wie Tetrafluormethan (CF4) zu machen.

Gemäß diesem Ausführungsbeispiel stellt der Schritt 3 des Fluorierens des Polymerresists eine Möglichkeit dar, bei der die Fluorierung auf der Oberseite des Wafers zwischen den Ausnehmungen einer gezielten lokalen, beispielsweise fotolithographisch definierten, Anpassung der Benetzungseigenschaften in diesen Bereichen dient. Durch den hier vorgestellten Ansatz sind weiterhin passive mikrofluidische Strukturen, wie beispielsweise Kanäle, Multiplexer, verschiedene Kompartimentalisierungsvorrichtungen und/oder Separationseinheiten auf Grundlage von Silizium und unter Bereitstellung geeigneter Benetzungseigenschaften, die beispielsweise für die Ausnutzung von Kapillareffekten nützlich sind, realisierbar.

Fig. 2 zeigt ein Ablaufdiagramm eines Ausführungsbeispiels eines Verfahrens 1000 zum Herstellen eines Trägerelements zum Aufnehmen einer Probenflüssigkeit. Das hier dargestellte Ablaufdiagramm enthält die in Fig. 1 beschriebenen Schritte 1, 2, 3 des Verfahrens 1000 und ist gemäß diesem Ausführungsbeispiel als Erweiterung des in Fig. 1 beschriebenen Verfahrens 1000 zu verstehen.

Es kann ferner im Schritt 1 des Beschichtens als Trägersubstrat 100 ein Substrat mit einer Oxidschicht und/oder mit einer Haftvermittlerschicht 104 beschichtetes Trägersubstrat 100 verwendet werden.

Gemäß diesem Ausführungsbeispiel umfasst das Verfahren 1000 somit einen optionalen Schritt 01 des Aufbringens eines Haftvermittlers auf das Trägersubstrat 100. Der Schritt 01 des Aufbringens wird dabei gemäß diesem Ausführungsbeispiel vor dem Schritt 1 des Beschichtens durchgeführt. Weiterhin optional umfasst das Verfahren 1000 einen Schritt 21 des Strukturierens des Trägersubstrats, um zumindest eine Ausnehmung in dem Trägersubstrat zu erhalten. Das bedeutet, dass das Strukturieren beispielsweise mittels eines Ätzvorgangs erfolgt, sodass beispielsweise das Trägersubstrat eine Volumenstruktur aufweist. Gemäß diesem Ausführungsbeispiel wird dabei beispielsweise in einem Schritt des reaktiven Ionentiefenätzens eine Passivierungsschicht auf eine Seitenwand der zumindest einen Ausnehmung aufgebracht. Die die Passivierungsschicht bildenden und an einer Seitenwand der Ausnehmung angeordneten Seitenwandpolymere werden beispielsweise anschließend im Schritt 3 des Fluorierens zumindest teilweise entfernt. Weiterhin umfasst das Verfahren 1000 gemäß diesem Ausführungsbeispiel einen Schritt 31 des Abscheidens einer Schicht, um eine Oberfläche des Trägersubstrats zu verändern und/oder abzudecken. Der Schritt 31 des Abscheidens erfolgt dabei gemäß diesem Ausführungsbeispiel nach dem Schritt 3 des Fluorierens und beschreibt beispielsweise ein Ablagern eines Stoffes auf dem Trägersubstrat.

In anderen Worten ausgedrückt wird vor dem Schritt 1 des Beschichtens die Oberfläche des Trägersubstrats mit beispielsweise dem Haftvermittler im Schritt 01 des Aufbringens versehen. Auf diese Weise kann eine stabilere Bindung der Polymerschicht an die Oberfläche des Trägersubstrats erzielt werden. Beispielsweise kann eine Siliziumoberfläche mit Hexamethyldisilazan (HMDS) oder einem Alkyltrichlorsilan vorbehandelt werden. Auf diese Weise kann insbesondere ein unerwünschtes Ablösen der Polymerschicht von der Oberfläche des Trägersubstrats durch mechanische oder chemische Beanspruchung verhindert werden. Weiterhin weist die Oberfläche des Trägersubstrats gemäß diesem Ausführungsbeispiel eine hydrophile Oberflächenbeschaffenheit auf. Dadurch wird beispielsweise eine Benetzung der Substratoberfläche mit wässrigen Lösungen begünstigt. Durch den hydrophoben Charakter der fluorierten Polymerschicht wirkt diese als Barriere für beispielsweise wässrige Phasen. Dadurch kann eine kontrollierte lokale Benetzung der Substratoberfläche erzielt werden. Durch die lokal angepasste Oberflächenbeschaffenheit wird beispielsweise eine selektive Benetzbarkeit der Teststruktur mit einer wässrigen Lösung erreicht.

Ferner wird gemäß diesem Ausführungsbeispiel die Polymerschicht als Resist oder eine Maske für den Schritt 21 des Strukturierens, wie beispielsweise mittels eines Ätzprozesses, zur Volumenstrukturierung des Trägersubstrats verwendet. Beispielsweise wird ein Siliziumsubstrat mittels eines reaktiven lonentiefenätzverfahrens strukturiert. Im Schritt 31 des Abscheidens erfolgt zusätzlich, aber optional eine selektive Abscheidung auf der Oberfläche des Siliziumsubstrats beispielsweise mittels einer chemischen Gasphasenabscheidung (CVD), Atomlagenabscheidung (ALD), mittels einer Anbindung einer selbst-assemblierten Monolage (SAM) oder unter Verwendung einer Silanverbindung, insbesondere einer Polyethylenglykolsilan-Verbindung. Dadurch wird beispielsweise eine modifizierte Substratoberfläche mit einem angepassten Benetzungsverhalten und gegebenenfalls einer besonders hohen Biokompatibilität hergestellt.

Im Schritt 1 des Beschichtens wird der polymerbasierte lichtsensitive Resist, der hier als Polymerschicht bezeichnet wird, auf das als ein Siliziumsubstrat ausgeformte Trägersubstrat beispielsweise durch Aufschleudern eines Lacks und anschließendes Erhitzen, um Lösemittelreste zu entfernen, aufgebracht. Optional wird vor dem Beschichten die Siliziumoberfläche mit einem Haftvermittler, beispielsweise mit Hexamethyldisilazan (HMDS) oder einem Alkyl-Trichlorsilan wie Octadecyltrichlorsilan, behandelt. Durch den Schritt 2 des Belichtens und Entwickelns der Polymerschicht, wird eine photolithographische Definition der lokal vorliegenden Benetzungseigenschaften und optional eine Maske für einen Ätzprozess gebildet. Durch ein Ätzen des Siliziumsubstrats im Schritt 21 des Strukturierens, beispielsweise mittels reaktivem lonentiefenätzen, wird eine definierte Mikrostrukturierung erzielt, um beispielsweise Kavitäten oder mikrofluidische Kammern und Kanäle herzustellen, die auch als Ausnehmungen bezeichnet werden.

Im Schritt 3 des Fluorierens wird das Trägersubstrat in einem Plasma mit einer fluorhaltigen Verbindung behandelt, insbesondere mit Tetrafluormethan (CF4), um eine Fluorierung der Polymeroberfläche der strukturierten Polymerschicht und gegebenenfalls eine geeignete Terminierung der übrigen Substratoberfläche zu erzielen. Danach wird im Schritt 31 des Abscheidens eine selektive Beschichtung der freiliegenden nicht von der Polymerschicht bedeckten Siliziumoberfläche beispielsweise durch chemische Gasphasenabscheidung (CVD) oder Atomlagenabscheidung (ALD) oder eine nasschemische Behandlung erfolgen. Dadurch wird beispielsweise eine Hydroxylierung der Siliziumoberfläche oder die Herstellung einer besonders biokompatiblen Oberfläche durch beispielsweise eine kovalente Anbindung eines Moleküls wie Polyethylenglykol (PEG) erreicht. Anschließend erfolgt optional eine Vereinzelung des Siliziumsubstrats durch beispielsweise mechanisches Sägen, laserbasiertes Vereinzeln ("Maho-Dicing") oder durch Brechen entlang von Sollbruchstellen, welche beispielsweise durch Ätzen in das Substrat eingebracht worden sind.

Durch die Verwendung einer fotolithographischen Methode wird einerseits eine Herstellung von mikrofluidischen Strukturen mit lokal angepassten Benetzungseigenschaften der Oberfläche mit einer sehr hohen Präzision und sehr kleinen Strukturgrößen im µm-Bereich erzielt, andererseits ist eine hochparallele Prozessierung auf großflächigen Substraten möglich, sodass dadurch beispielsweise eine kostengünstige Fertigbarkeit des Trägerelements gegeben ist.

Durch die Verwendung einer polymerbasierten lichtsensitiven Polymerschicht sowohl als Maske für den Ätzprozess als auch als Grundlage für die Erzeugung einer hydrophoben Beschichtung der Substratoberseite ist weiterhin ein einziger Lithographie-Schritt ausreichend, um sowohl eine definierte Mikrostrukturierung des Siliziumsubstrats zu erzielen als auch um eine Anpassung des Benetzungsverhaltens in den Bereichen zu ermöglichen, welche sich auf der Oberseite des Substrats zwischen den geätzten Strukturen befinden. Durch eine mittels des Verfahrens 1000 bereitgestellte Hydrophobisierung des Trägersubstrats wird insbesondere in vorteilhafter Weise ein fluidisches Quersprechen beispielsweise zwischen benachbarten in das Siliziumsubstrat über den Schritt 21 des Strukturierens eingebrachte Strukturen unterbunden. Insgesamt ist durch das Verfahren 1000 eine besonders einfache und kostengünstige Fertigung von mikrostrukturierten Silizium-Bauteilen mit lokal angepasstem Benetzungsverhalten möglich. Gemäß diesem Ausführungsbeispiel wird durch eine auf den Ätzprozess folgende Tetrafluormethan (CF4)-Plasmabehandlung im Schritt 3 des Fluorierens sowohl eine Fluorierung der Polymeroberfläche, als auch eine Reinigung der in das Siliziumsubstrat geätzten Strukturen erreicht. Dies führt gemäß diesem Ausführungsbeispiel einerseits dazu, dass die Polymeroberfläche ein besonders hydrophobes, also wasserabweisendes, Verhalten aufweist und andererseits wird gleichzeitig eine Reinigung und/oder Terminierung der Oberfläche der in das Siliziumsubstrat geätzten Struktur erreicht. Insbesondere werden beispielsweise durch die CF4-Plasmabehandlung aus einem reaktiven lonentiefenätzprozess stammende Seitenwandpolymere zumindest teilweise entfernt und eine hydrophile Siliziumoberfläche erzeugt. Weiterhin wird gemäß diesem Ausführungsbeispiel durch eine Fluorierung der polymeren Photoresist-Oberfläche im darauffolgenden Schritt 31 des Abscheidens eine selektive Beschichtung der nicht mit der strukturierten fluorierten Polymerschicht bedeckten Siliziumoberfläche beispielsweise durch chemische Gasphasenabscheidung (CVD), Atomlagenabscheidung (ALD) oder durch eine anderweitige chemische Behandlung erreicht. Dadurch wird beispielsweise das Benetzungsverhalten der nicht mit dem Polymer-Resist bedeckten Siliziumoberfläche weiter angepasst und/oder eine besonders gute Biokompatibilität der erzeugten Strukturen hergestellt.

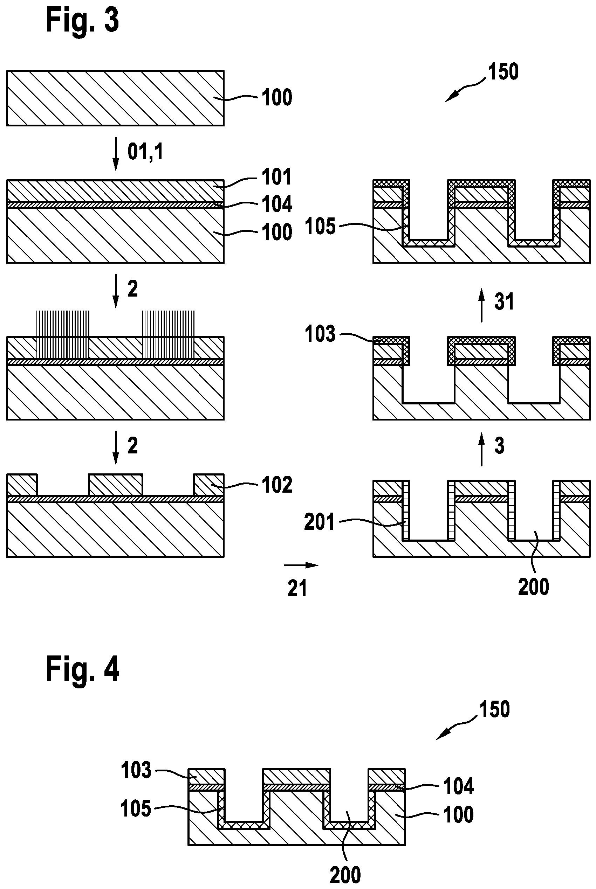

Fig. 3 zeigt eine schematische Darstellung verschiedener Zwischenprodukte eines Trägerelements 150 gemäß einem Ausführungsbeispiel während eines Verfahrens zum Herstellen des Trägerelements 150 zum Aufnehmen einer Probenflüssigkeit. Gemäß diesem Ausführungsbeispiel wird das hier dargestellte Trägerelement 150 mittels des Verfahrens hergestellt, wie es in Fig. 2 beschrieben wurde. Gemäß diesem Ausführungsbeispiel ist dem entsprechend das Teilergebnis nach jedem Schritt 01, 1, 2, 21, 3, 31 des Verfahrens 1000 abgebildet.

Gemäß diesem Ausführungsbeispiel wird das Trägersubstrat 100 im Schritt 1 des Beschichtens mit der Polymerschicht 101 beschichtet. Gemäß diesem Ausführungsbeispiel ist zwischen dem Trägersubstrat 100 und der Polymerschicht der Haftvermittler 104 angeordnet. Nach dem Schritt 2 des Belichtens und Entwickelns weist das Trägerelement 150 die strukturierte Polymerschicht 102 auf. Das bedeutet, dass gemäß diesem Ausführungsbeispiel die Polymerschicht 101 bei dem Entwickeln an der Position abgetragen wird, auf die bei dem Belichten die Lichtstrahlen treffen, um die strukturierte Polymerschicht 102 zu erhalten. Im Schritt 21 des Strukturierens wird das Trägersubstrat 100 strukturiert, indem beispielsweise Ausnehmungen 200 in das Trägersubstrat 100 geätzt werden. Die Herstellung der Ausnehmungen erfolgt insbesondere durch einen Schritt des reaktiven lonentiefenätzens, wobei eine Passivierungsschicht 201 in Form von Seitenwandpolymeren auf das Trägersubstrat 100 und/oder die strukturierte Polymerschicht 102 aufgebracht wird. Die Seitenwandpolymere werden im Schritt 3 des Fluorierens (zumindest teilweise) abgetragen und die strukturierte Polymerschicht 102 fluoriert, um beispielsweise eine fluorierte Polymerschicht 103 zu erhalten, die hydrophob ausgeformt ist. Im Schritt 31 des Abscheidens wird eine Schicht 105 auf eine Oberfläche der Ausnehmungen 200 abgeschieden, die hydrophil ist.

In anderen Worten ausgedrückt wird als Trägersubstrat 100 ein Siliziumwafer verwendet, welcher mit Hexamethyldisilazan (HMDS) als Haftvermittler 104 vorbehandelt 01 und auf den mittels Aufschleuderns ein Fotolack/Polymer-Resist 101 im Schritt 1 des Beschichtens aufgebracht wurde. Nach der lokalen Belichtung im Schritt 2 des Belichtens und Entwickelns erfolgt der Schritt 21 des Strukturierens, beispielsweise in Form eines reaktiven lonentiefenätzprozesses zur Volumenstrukturierung des auch als Siliziumsubstrat bezeichneten Trägersubstrats 100. Beispielsweise wird durch eine anschließende Behandlung des Trägersubstrats 100 in beispielsweise einem Niederdruck-Plasma mit Anteilen von CF4 im Schritt 3 des Fluorierens eine Fluorierung der übrig gebliebenen Polymerschicht 103 erzielt, sowie eine zumindest teilweise Entfernung der als Seitenwandpolymere ausgeformten Passivierungsschicht 201 an der Oberfläche der Ausnehmungen 200 erreicht, die auch als geätzte Struktur oder als Volumenstrukturierung bezeichnet werden. Darauffolgend kann die Aufbringung der Schicht 105 als selektive Abscheidung im Schritt 31 des Abscheidens auf dem Trägersubstrat 100 erfolgen, beispielsweise mittels chemischer Gasphasenabscheidung (CVD), Atomlagenabscheidung (ALD), Anbindung einer selbst-assemblierten Monolage (SAM) oder unter der Verwendung einer Silanverbindung, insbesondere einer Polyethylenglykolsilan-Verbindung. Die Polymeroberfläche der auch als Photoresist bezeichneten fluorierten Polymerschicht 103 bleibt durch die vorangegangene Fluorierung 3 der Oberfläche unberührt, sodass eine Selektivität des Schritts 31 des Abscheidens erreicht wird.

Fig. 4 zeigt eine schematische Querschnittsdarstellung eines Trägerelements 150 gemäß einem Ausführungsbeispiel. Das Trägerelement 150 kann dabei dem in Fig. 3 beschriebenen Trägerelement 150 entsprechen oder zumindest ähneln und dem entsprechend durch ein Verfahren hergestellt worden sein, wie es in einer der Figuren 1 und/oder 2 beschrieben wurde.

Gemäß diesem Ausführungsbeispiel ist das Trägerelement 150 als ein mikrofluidisches Bauteil ausgeformt. Das Trägerelement 150 besteht aus dem mikrostrukturierten Trägersubstrat 100, welches an seiner Oberseite über die strukturierte und fluorierte Polymerschicht 103 verfügt, die mittels des Haftvermittlers 104 auf das Trägersubstrat 100 aufgebracht ist. Ferner befinden sich in dem Substrat 100 die Ausnehmungen 200, deren Oberfläche eine hydrophile Schicht 105 aufweist.

Das Trägerelement 150 ist ausgebildet, um die Probenflüssigkeit aufzunehmen. Das Trägerelement 150 weist dazu das Trägersubstrat 100 mit einer hydrophilen Oberflächenbeschaffenheit und die an dem Trägersubstrat angeordnete oder anordbare fluorierte Polymerschicht 103 mit der hydrophoben Oberflächenbeschaffenheit auf.

Das Trägersubstrat 100 ist beispielsweise aus einem siliziumhaltigen Material ausgeformt, das beispielsweise eine Dicke zwischen 100 µm und 3 mm, bevorzugt zwischen 300 µm und 1000 µm aufweist. Die Polymerschicht 103 weist beispielsweise eine Dicke zwischen 500 nm und 10 µm auf, bevorzugt aber zwischen 1 µm und 5 µm. Gemäß diesem Ausführungsbeispiel ist die Polymerschicht 103 beispielsweise als ein Phenolharz realisiert oder realisierbar. Die zumindest eine Ausnehmung 200 des Trägersubstrats 100 weist beispielsweise eine Strukturgröße auf, die beispielsweise zwischen 500 nm und 30 mm, bevorzugt jedoch zwischen 5 µm und 1 mm liegt.

Weiterhin weist das Trägerelement 150 beispielsweise eine Größe auf, die zwischen 1 x 1 mm² und 100 x 100 mm² liegt. Gemäß diesem Ausführungsbeispiel weist das Trägerelement 150 vorzugsweise eine Größe zwischen 3 x 3 mm² und 10 x 10 mm² auf.

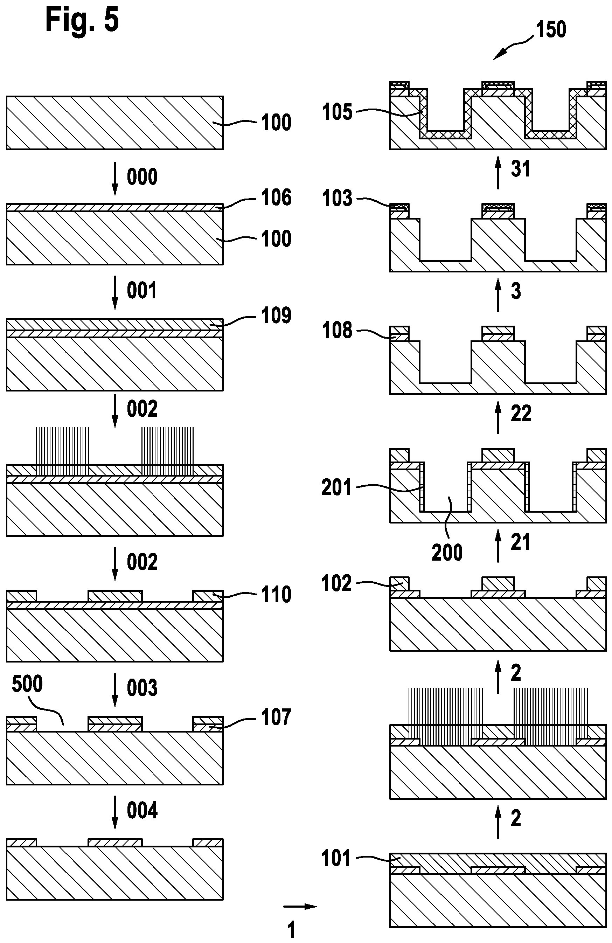

Fig. 5 zeigt eine schematische Darstellung verschiedener Zwischenprodukte eines Trägerelements 150 gemäß einem Ausführungsbeispiel während der Durchführung eines Verfahrens zum Herstellen des Trägerelements 150. Gemäß diesem Ausführungsbeispiel wird das hier dargestellte Trägerelement 150 mittels des Verfahrens hergestellt, wie es in einer der Figuren 1 bis 3 beschrieben wurde. Das Verfahren ist dabei erweitert dargestellt, sodass gemäß diesem Ausführungsbeispiel zusätzlich zu den in zumindest einer der vorangehenden Figuren beschriebenen Schritte 01, 1, 2, 21, 3, 31 weitere optionale Schritte 000, 001, 002, 003, 004, 22 des Verfahrens 1000 im Folgenden näher beschrieben werden.

Das Trägersubstrat 100 weist gemäß diesem Ausführungsbeispiel die Oxidschicht 106 auf, die auf dem Trägersubstrat 100 angeordnet ist. Weiterhin optional kann zusätzlich die Aufbringung eines Haftvermittlers auf die Oxidschicht erfolgen, um eine bessere Bindung der Polymerschicht an das Substrat mit der Oxidschicht zu erzielen. Gemäß diesem Ausführungsbeispiel sind die Teilergebnisse der einzelnen Schritte des Verfahrens abgebildet. Zusätzlich zu den in Fig. 1 und/oder 2 beschriebenen Verfahrensschritte umfasst das Verfahren weiterhin einen Schritt 001 des Aufbringens einer weiteren lichtsensitiven Polymerschicht 109 auf das Trägersubstrat 100. Gemäß diesem Ausführungsbeispiel weist die weitere Polymerschicht 109 die gleichen lichtsensitiven Eigenschaften auf wie die Polymerschicht 101, mit der das Trägersubstrat 100 gemäß diesem Ausführungsbeispiel zu einem späteren Zeitpunkt beschichtet wird.

Das Verfahren umfasst weiterhin einen Schritt 002 des weiteren Belichtens und Entwickelns der weiteren Polymerschicht 109, um eine weitere strukturierte Polymerschicht 110 zu erhalten. Außerdem umfasst das Verfahren gemäß diesem Ausführungsbeispiel weiterhin einen weiteren Schritt 003 des Strukturierens nach dem Schritt 002 des weiteren Belichtens und Entwickelns, um zumindest eine Strukturierung 500 der Oxidschicht 106 auf dem Trägersubstrat 100 zu erhalten. Genauer gesagt wird im weiteren Schritt 003 des Strukturierens die Oxidschicht 106 gemäß diesem Ausführungsbeispiel teilweise geöffnet, sodass eine strukturierte Oxidschicht 107 vorliegt. Weiterhin optional wird gemäß diesem Ausführungsbeispiel die weitere strukturierte Polymerschicht 110 in einem Schritt 004 des Entfernens entfernt, bevor das Trägersubstrat 100 im Schritt 1 des Beschichtens mit der Polymerschicht 101, wie in einer der Figuren 1 bis 4 beschrieben, beschichtet wird. Anschließend folgen auch gemäß diesem Ausführungsbeispiel der Schritt 2 des Belichtens und Entwickelns sowie der Schritt 21 des Strukturierens des Trägersubstrats 100. Optional umfasst das Verfahren gemäß diesem Ausführungsbeispiel einen Schritt 22 des Öffnens der strukturierten und teilweise geöffneten Oxidschicht 107 unter Ausnutzung der strukturierten Polymerschicht (102), um die geöffnete Oxidschicht 108 zu erhalten, die gemäß diesem Ausführungsbeispiel nach dem Schritt 22 beispielsweise die gleichen Abmessungen wie die strukturierte Polymerschicht 102 aufweist. Gemäß diesem Ausführungsbeispiel wird die strukturierte Polymerschicht 102 im Schritt 3 des Fluorierens anschließend fluoriert, um die strukturierte Polymerschicht 102 hydrophob zu machen. Schließlich wird im Schritt 31 des Abscheidens die Schicht 105 mit einer hydrophilen Oberflächenbeschaffenheit auf dem Trägersubstrat 100 abgeschieden.

In anderen Worten ausgedrückt wird beispielsweise in einem Schritt 000 des Erzeugens zunächst die Oxidschicht 106 auf dem Trägersubstrat 100 erzeugt. Dies ist beispielsweise durch thermische Oxidation oder eine chemische Gasphasenabscheidung möglich. Nach dem Schritt 001 des Aufbringens der als Polymerresist bezeichenbaren weiteren Polymerschicht 109 und anschließendes weiteres Belichten und Entwickeln 002 der weiteren Polymerschicht 109 wird die dadurch weitere strukturierte Polymerschicht 110 zum definierten Öffnen der Oxidschicht 106, was gemäß diesem Ausführungsbeispiel im weiteren Schritt 003 des Strukturierens bewirkt wird, eingesetzt. Die geöffnete Oxidschicht 107 dient im späteren Schritt 21 des Strukturierens als Maske für die Volumenstrukturierung des Trägersubstrats 100.

Nach dem Schritt 004 des Entfernens der weiteren strukturierten Polymerschicht 110 wird die Polymerschicht 101 auf das Trägersubstrat 100 mit der strukturierten Oxidschicht 107 im Schritt 1 des Beschichtens aufgebracht. Die Polymerschicht 101 dient in einem späteren Schritt 3 des Fluorierens zur Erzeugung der strukturierten fluorierten Polymerschicht 103 auf dem Trägersubstrat 100. Zu diesem Zweck wird die Polymerschicht 101 im Schritt 2 des Belichtens und Entwickelns zunächst lokal belichtet und anschließend entwickelt.

Gemäß diesem Ausführungsbeispiel wird die teilweise geöffnete Oxidschicht 107 und/oder die strukturierte Polymerschicht 102 als Maske für einen Ätzschritt, das bedeutet für den Schritt 21 des Strukturierens zur Volumenstrukturierung 200 des Trägersubstrats 100 beispielsweise mittels reaktivem Ionentiefenätzens eingesetzt. Nach dem Schritt 22 des Öffnens der Oxidschicht 107 in den nicht von der strukturierten Polymerschicht 102 bedeckten Bereichen des Trägersubstrats 100 erfolgt der Schritt 3 des Fluorierens der strukturierten Polymerschicht 102 in beispielsweise einem CF4-Plasma, um die fluorierte Polymerschicht 103 zu erhalten. Schließlich wird über eine selektive Abscheidung im Schritt 31 des Abscheidens die funktionale Schicht 105 auf der freien Siliziumoberfläche des Trägersubstrats 100 erzeugt, beispielsweise mittels chemischer Gasphasenabscheidung (CVD), Atomlagenabscheidung (ALD) oder Anbindung einer selbstassemblierten Monolage (SAM) oder unter der Verwendung einer Silanverbindung, insbesondere einer Polyethylenglykol-SilanVerbindung, um vorteilhafterweise eine biokompatible, hydrophile Oberfläche zu erzeugen. Das Trägerelement 150 weist dazu insbesondere neben der Ausnehmung 200 zusätzlich ein lokal angepasstes Benetzungsverhalten auf, welches unabhängig von der Form der Ausnehmung 200 des Trägersubstrates 100 definiert ist. In einem vorteilhaften Ausführungsbeispiel des Trägerelements 150, das auch als Bauteil bezeichnet wird, werden beispielsweise an den Ausnehmungen 200 oder Kavitäten angrenzende Bereiche des Trägerelements, beispielsweise der Chip-Oberseite, mit einer hydrophilen Schicht 105 gestaltet, um ein Eindringen von beispielsweise wässrigen Flüssigkeiten in die Ausnehmungen 200 oder Kavitäten in dem Trägersubstrat 100 zu erleichtern.

In einer vorteilhaften hier dargestellten Weiterbildung des Verfahrens wird beispielsweise mittels eines zusätzlichen zweiten photolithografischen Schrittes eine lokal definierte Anpassung der Benetzungseigenschaften an der Oberseite des Trägerelements 150 erzielt. Auf diese Weise wird auf der Oberseite in definierten Teilbereichen ein vergleichbares Benetzungsverhalten wie in den im Schritt 21 des Strukturierens erzeugten Strukturen erreicht werden. Insbesondere wird eine hydrophile Oberflächenbeschaffenheit hergestellt, welche eine gute Benetzbarkeit dieser Teilbereiche der Oberseite mit einer wässrigen Lösung erlaubt, während in den übrigen Bereichen der Oberseite durch eine hydrophobe Oberflächenbeschaffenheit eine Benetzung mit einer wässrigen Lösung unterbunden wird. Auf diese Weise lassen sich noch komplexere mikrofluidische Strukturen in dem Trägerelement 150 erzeugen. In besonders vorteilhafter Weise wird ein derartiges Bauteil in Kombination mit einer weiteren, insbesondere aus einem Polymer-Material bestehenden Komponente eingesetzt.

Das Verfahren erlaubt gemäß diesem Ausführungsbeispiel insbesondere die Fabrikation von Siliziumchips mit mikrofluidischen Mikrokavitäten-Arrays, welche über Mikrokavitäten mit einer hydrophilen Oberflächenbeschaffenheit verfügen und eine in vorgegebenen Teilbereichen hydrophobe Chip-Oberseite aufweisen. Die hydrophilen Mikrokavitäten weisen einerseits eine hohe Affinität zu wässrigen Lösungen auf, andererseits wird nach einer Versiegelung der mit einer wässrigen Phase vorab befüllten Mikrokavitäten mit einer zweiten Phase, beispielsweise mit einem Öl wie Mineralöl, Paraffinöl oder Silikonöl, einem PDMS-Präpolymer oder einem fluorierten Kohlenwasserstoff, wie beispielsweise Fomblin, 3M Fluorinert FC-40, FC-70, oder Novec 7500, gegebenenfalls eine Aliquotierung der wässrigen Phase in den Mikrokavitäten erzielt.

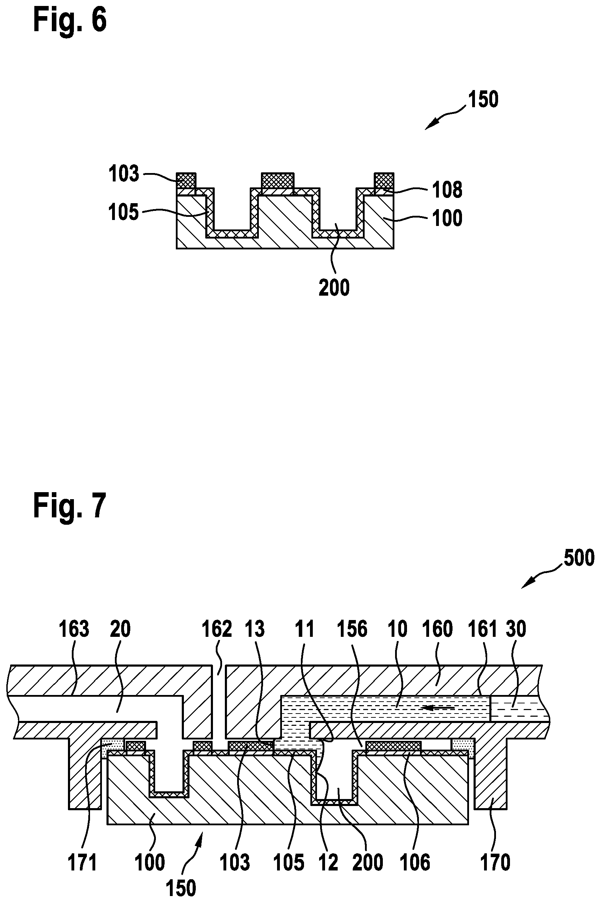

Fig. 6 zeigt eine schematische Querschnittsdarstellung eines Trägerelements 150 gemäß einem Ausführungsbeispiel. Das hier dargestellte Trägerelement 150 kann dem in Fig. 5 beschriebenen Trägerelement 150 entsprechen oder zumindest ähneln. Gemäß diesem Ausführungsbeispiel ist das hier dargestellte Trägerelement 150 weiterhin in einem Verfahren herstellbar, wie es in Fig. 5 beschrieben wurde. Das Trägerelement 150 weist gemäß diesem Ausführungsbeispiel eine strukturierte Oxidschicht 108, eine auf der strukturierten Oxidschicht 108 angeordnete fluorierte Polymerschicht 103 sowie an freiliegenden Flächen des Trägersubstrats 100 eine hydrophile Schicht 105 auf. Weiterhin weist das Trägerelement 150 zumindest eine Ausnehmung 200 auf. Das bedeutet, dass das hier dargestellte Trägerelement 150 erzeugt werden kann als Endprodukt des in Fig. 5 beschriebenen Verfahrens, das wiederum als eine Erweiterung der in Fig. 1 und/oder 2 beschriebenen Verfahren zu verstehen ist.

In anderen Worten ausgedrückt ist eine schematische Darstellung eines Querschnitts des als Trägerelement 150 bezeichneten mikrofluidischen Bauteils abgebildet, welches gemäß der in Fig. 5 beschriebenen vorteilhaften Weiterbildung des Verfahrens hergestellt wurde. Das Trägerelement 150 besteht aus einem mikrostrukturierten Trägersubstrat 100, in dem sich Ausnehmungen 200 befinden. Die Ausnehmungen verfügen über eine hydrophile und insbesondere biokompatible Schicht 105, die auch als Oberflächenfunktionalisierung bezeichnet wird. Eine Oberseite des Trägerelements 150 verfügt über verschiedenartige, das bedeutet hydrophile und hydrophobe Bereiche, die ein unterschiedliches Benetzungsverhalten für beispielsweise wässrige Lösungen aufweisen. Die hydrophoben Teilbereiche der Oberseite des Trägerelements 150 verfügen über eine fluorierte Polymerschicht 103, während die hydrophilen Bereiche über dieselbe Schicht 105 wie die in das Trägersubstrat 100 eingebrachten Ausnehmungen 200 verfügen. Durch die spezielle Beschaffenheit des Trägerelements 150 bezüglich Geometrie und Oberflächeneigenschaften ist dieses für eine durch Kapillarkräfte assistierte Prozessierung einer Probenflüssigkeit in einem mikrofluidischen System einsetzbar.

Fig. 7 zeigt eine schematische Querschnittsdarstellung eines Trägermoduls 500 gemäß einem Ausführungsbeispiel. Das Trägermodul 500 weist dabei ein Trägerelement 150 zum Aufnehmen einer Probenflüssigkeit 10 und ein mit dem Trägerelement 150 verbindbares oder verbundenes Deckelelement 160 auf, das ausgebildet ist, um die Probenflüssigkeit 10 auf das Trägerelement 150 aufzubringen. Das Trägermodul 500 ist dabei beispielsweise als eine Einmal-Kartusche ausgeformt. Das hier dargestellte Trägerelement 150 kann dabei beispielsweise dem in einer der Figuren 3 bis 6 beschriebenen Trägerelement 150 entsprechen oder zumindest ähneln. Gemäß diesem Ausführungsbeispiel ist das Trägerelement 150 durch ein Verfahren herstellbar, wie es beispielsweise in einer der Figuren 1, 2, 3 und/oder 5 beschrieben wurde.

Gemäß diesem Ausführungsbeispiel wird das Trägerelement 150 mit lokal angepassten Benetzungseigenschaften der Oberfläche in Kombination mit wenigstens einer weiteren Komponente, die hier als Deckelelement 160 bezeichnet ist, beispielsweise einem strukturierten Polymersubstrat verwendet. Das Deckelelement ist dabei beispielsweise aus einem Polymer, wie beispielsweise Polycarbonat, Polypropylen, Polyethylen, Cycloolefin-Copolymer oder Polymethylmethacrylat ausgeformt und beispielsweise mittels Spritzgießen herstellbar. Gemäß diesem Ausführungsbeispiel ist dabei eine relative Position des Trägerelements 150 gegenüber der Position des Deckelelements 160 hinreichend eingeschränkt, um einen Transport von wenigstens der einen Probenflüssigkeit 10 zwischen dem Deckelelement 160 und dem Trägerelement 150 zu ermöglichen. Das Deckelelement 160 und das Trägerelement 150 bilden gemäß diesem Ausführungsbeispiel das Trägermodul 500, das beispielsweise als eine Einmal-Kartusche realisiert ist.

Optional verfügt das Deckelelement 160 hierzu über zumindest ein Justageelement 170, welches die relative Position des Trägerelements 150 in Bezug zum Deckelelement 160 genau festsetzt. Gemäß diesem Ausführungsbeispiel ist das Trägerelement 150 optional mit dem Deckelelement 160 über beispielsweise eine Klebeverbindung 171 fest miteinander verbunden. Ferner verfügt das Deckelelement 160 insbesondere über wenigstens einen Kanal 161 zum Transport der Probenflüssigkeit 10 zu dem Trägerelement 150 über einen Raum 156, der zwischen dem Trägerelement 150 und dem Deckelelement 160 angeordnet ist. Gemäß diesem Ausführungsbeispiel grenzt an den Raum 156 die fluorierte Polymerschicht 103 an, mit der das Trägersubstrat 100 nach dem in einer der vorangegangen Figuren beschriebenen Verfahren beschichtet wurde und die aufgrund ihrer hydrophoben Oberflächenbeschaffenheit ein Durchtreten von der beispielsweise über den Kanal 161 in den Raum 156 eingebrachten Probenflüssigkeit 10 durch die zwischen dem Trägerelement 150 und dem Deckelelement 160 optional vorliegenden Kapillar-Spalte unterbindet. Hierzu weist das Deckelelement 160 gemäß diesem Ausführungsbeispiel insbesondere eine unpolare, hydrophobe oder nur schwach hydrophile Oberflächenbeschaffenheit auf, sodass bei einem in Kontakttreten der Oberfläche des Deckelelements 160, das beispielsweise als ein Polymersubstrat ausgeformt ist, mit der beispielsweise wässrigen Probenflüssigkeit 10 sich ein entsprechend großer Kontaktwinkel 11 ausbildet, der einem unerwünschten fluidischen Quersprechen über Spalte zwischen unterschiedlichen flüssigkeitsführenden hydrophilen Bereichen, die als hydrophile Schicht 105 ausgeformt sind, auf der Oberseite des Trägerelements 150 entgegenwirkt.

Das Trägermodul 500 weist gemäß diesem Ausführungsbeispiel einen insbesondere in das Deckelelement 160 integrierten Entlüftungskanal 162 auf, über den eine Verdrängung von eines in dem Trägermodul 500 vorliegenden gasförmigen Mediums 20 gemäß diesem Ausführungsbeispiel möglich ist. Unabhängig davon ist eine Entlüftung auch über einen weiteren Kanal 163 in dem Deckelelement 160 realisierbar. Der Kanal 163 ist darüber hinaus lediglich optional für einen (Rück-)Transport der Probenflüssigkeit 10 von dem Trägerelement 150 in das Deckelelement 160 vorgesehen. Weiterhin optional ist das Trägermodul 500 gemäß diesem Ausführungsbeispiel für einen Einsatz mit einer weiteren Flüssigkeit 30 verwendbar, welche insbesondere nicht mit der Probenflüssigkeit 10 mischbar ist. Dabei ist in das Deckelelement 160 eine mikrofluidische Pumpvorrichtung zum Transport der Probenflüssigkeit 10 integriert oder integrierbar. Eine Ansteuerung der Pumpvorrichtung erfolgt gemäß einem Ausführungsbeispiel über eine Schnittstelle zu einer Prozessierungseinheit. Die Pumpvorrichtung ist insbesondere mittels einer elastischen Membran realisiert, wobei die Ansteuerung der Pumpvorrichtung mittels der externen Prozessierungseinheit über das Anlegen wenigstens zweier unterschiedlicher Druckniveaus an eine pneumatische Schnittstelle zu dem Deckelelement 160 erfolgt.

Gemäß diesem Ausführungsbeispiel weisen die Querschnitte der Kanäle 161, 163 beispielsweise solche Abmessungen auf, die sich beispielsweise in einem Bereich zwischen 100 x 100 µm² bis 2 x 2 mm² befinden. Bevorzugt weisen die Kanäle 161, 162, 163 jedoch gemäß diesem Ausführungsbeispiel 300 x 300 µm² bis 800 x 800 µm² auf. Die Ausnehmungen 200 weisen weiterhin beispielsweise eine Größe zwischen 1 x 1 x 1 µm² und 1 x 1 x 1 mm² und bevorzugt zwischen 10 x 10 x 10 µm² und 500 x 500 x 500 µm² auf.

Das Deckelelement 160 ist gemäß diesem Ausführungsbeispiel kostengünstig aus wenigstens einem Polymermaterial gefertigt. Die eine oder optional mehrere weitere(n) mikrostrukturierte(n) Komponente(n) bilden dabei optional in Verbindung mit dem wenigstens einen Trägerelement 150 eine Lab-on-Chip Kartusche. Das Trägermodul 500 weist insbesondere die folgenden Vorteile auf:
Durch die Kombination eines Trägerelements 150 mit wenigstens einem Deckelelement 160 wird ein Abschluss und/oder eine Begrenzung des über der Chip-Oberseite des Trägerelements 150 vorliegenden Raumes erzielt. Dadurch wird - insbesondere bei einer hydrophoben oder nur schwach hydrophilen Oberflächenbeschaffenheit des Deckelelements 160 - insbesondere ein Übertreten von wässrigen Lösungen über die Bereiche des Trägerelements 150 mit einer hydrophoben Oberflächenbeschaffenheit aufgrund des sich dort aufbauenden Kapillardruckes vermieden. Auf diese Weise wird eine Prozessierung von wässrigen Lösungen in den hydrophilen Bereichen und den eingeätzten Strukturen des Trägerelements 150 ermöglicht, wobei die hydrophoben Bereiche der Oberfläche als Barriere dienen und für ein Guiding der Probenflüssigkeit einsetzbar sind. Durch den hier vorgestellten Ansatz wird eine einfache mikrofluidische Integration eines nach dem Verfahren hergestellten Trägerelements in eine mikrofluidische Umgebung aus Polymermaterial erlaubt. Durch die Verwendung von Polymermaterialien für eine Bildung des Deckelelements 160 ist sowohl eine kostengünstige Fertigung des Trägermoduls 500 in hohen Stückzahlen beispielsweise unter Verwendung von Hochdurchsatzverfahren wie Spritzgießen und Laserverschweißen von Polymerkomponenten, als auch eine Prozessierung größerer Fluidvolumina im Bereich von einigen zehn oder hundert Mikrolitern in dem Trägermodul 500 möglich, welche beispielsweise für die Durchführung von molekulardiagnostischen Testabläufen zum Einsatz kommen.

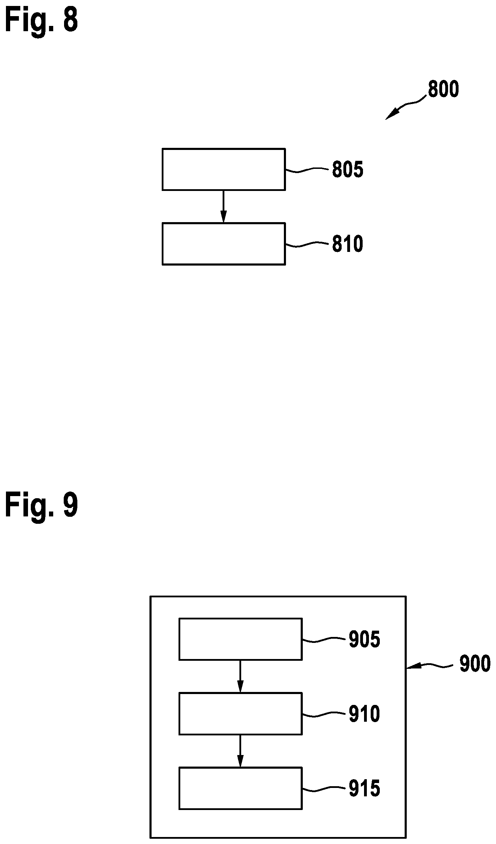

Fig. 8 zeigt ein Ablaufdiagramm eines Verfahrens 800 zum Verwenden eines Trägermoduls 500 gemäß einem Ausführungsbeispiel. Das Verfahren 800 umfasst dabei einen Schritt 805 des in Kontaktbringens der Probenflüssigkeit mit dem Deckelelement 160 und einen Schritt 810 des in Kontaktbringens der Probenflüssigkeit mit einer Oberfläche des Trägerelements 150. Das in dem Verfahren 800 verwendete Trägerelement kann beispielsweise dem in einer der Figuren 3 bis 7 beschriebenen Trägerelement entsprechen oder ähneln. Weiterhin kann das verwendete Trägerelement durch ein Verfahren hergestellt worden sein, wie es in einer der Figuren 1 oder 2 beschrieben wurde.

Fig. 9 zeigt ein Blockschaltbild einer Vorrichtung 900 gemäß einem Ausführungsbeispiel. Die Vorrichtung 900 ist dabei ausgebildet um ein Verfahren zum Herstellen eines Trägerelements zum Aufnehmen einer Probeflüssigkeit anzusteuern oder durchzuführen, wie es in einer der Figuren 1 bis 3 oder 5 beschrieben wurde. Die Vorrichtung 900 weist dabei eine Einheit 905 zum Beschichten eines Trägersubstrats mit einer lichtsensitiven Polymerschicht auf, um ein beschichtetes Trägersubstrat zu erhalten, insbesondere wobei das Trägersubstrat eine hydrophile Oberflächenbeschaffenheit aufweist. Ferner umfasst die Vorrichtung 900 eine Einheit 910 zum Belichten und Entwickeln des beschichteten Trägersubstrats, um eine strukturierte Polymerschicht zu erhalten und eine Einheit 915 zum Fluorieren der auf dem Trägersubstrat angeordneten strukturierten Polymerschicht, um das Trägerelement zum Aufnehmen der Probenflüssigkeit herzustellen, insbesondere wobei die strukturierte Polymerschicht durch den Schritt des Fluorierens eine hydrophobe Oberflächenbeschaffenheit erhält.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (1000) zum Herstellen eines Trägerelements (150) zum Aufnehmen einer Probenflüssigkeit (10) mit einer auf dem Trägersubstrat angeordneten Polymerschicht (103) mit einer hydrophoben Oberflächenbeschaffenheit, wobei das Verfahren (1000) die folgenden Schritte umfasst:
- Beschichten (1) eines Trägersubstrats (100) mit einer lichtsensitiven Polymerschicht (101), um ein beschichtetes Trägersubstrat (100) zu erhalten, insbesondere wobei das Trägersubstrat (100) eine hydrophile Oberflächenbeschaffenheit aufweist;
- Belichten (2) und Entwickeln des beschichteten Trägersubstrats (100), um eine strukturierte Polymerschicht (102) zu erhalten; und
- Fluorieren (3) der auf dem Trägersubstrat (100) angeordneten strukturierten Polymerschicht (102), um das Trägerelement (150) zum Aufnehmen der Probenflüssigkeit (10) herzustellen, wobei die strukturierte Polymerschicht (102) durch den Schritt (3) des Fluorierens eine hydrophobe Oberflächenbeschaffenheit erhält, **gekennzeichnet durch** Abscheiden einer Schicht (105) nach dem Schritt (3) des Fluorierens, um eine Oberfläche des Trägersubstrats (100) zu verändern und/oder abzudecken, sodass eine Seitenwand von zumindest einer Ausnehmung (200) in dem Trägersubstrat (100) hydrophil ausgeformt ist.

2. Verfahren (1000) gemäß Anspruch 1, wobei im Schritt (1) des Beschichtens das Trägersubstrat (100) beschichtet wird, welches zumindest teilweise aus einem Halbleitermaterial, insbesondere einem siliziumhaltigen Material ausgeformt ist.

3. Verfahren (1000) gemäß einem der vorangegangenen Ansprüche, mit einem Schritt (21) des Strukturierens des Trägersubstrats (100), um die zumindest eine Ausnehmung (200) in dem Trägersubstrat (100) zu erhalten.

4. Verfahren (1000) gemäß Anspruch 3, wobei in dem Schritt (21) des Strukturierens eine Passivierungsschicht (201) auf zumindest einer Seitenwand der zumindest einen Ausnehmung (200) erzeugt wird, und wobei im Schritt (3) des Fluorierens die an zumindest einer Seitenwand der Ausnehmung (200) angeordnete Passivierungsschicht zumindest teilweise entfernt wird.

5. Verfahren (1000) gemäß einem der vorangegangenen Ansprüche, wobei im Schritt (1) des Beschichtens als Trägersubstrat (100) ein Substrat mit einer Oxidschicht (106) und/oder mit einer Haftvermittlerschicht (104) beschichtetes Trägersubstrat (100) verwendet wird.

6. Verfahren (1000) gemäß einem der vorangegangenen Ansprüche, mit einem Schritt (001) des Aufbringens einer weiteren lichtsensitiven Polymerschicht (109), und mit einem Schritt (002) des weiteren Belichtens und Entwickelns der weiteren Polymerschicht (109), um eine weitere strukturierte Polymerschicht (110) zu erhalten.

7. Verfahren (1000) gemäß Anspruch 6, mit einem weiteren Schritt (003) des Strukturierens nach dem Schritt (002) des weiteren Belichtens und Entwickelns, um zumindest eine weitere Strukturierung (500), insbesondere eine Strukturierung einer auf dem Trägersubstrat (100) vorliegenden Oxidschicht (106) zu erhalten.

8. Steuergerät (900), das eingerichtet ist, um die Schritte (1, 2, 3) des Verfahrens (1000) gemäß einem der vorangegangenen Ansprüche in entsprechenden Einheiten (905, 910, 915) auszuführen und/oder anzusteuern.

9. Computerprogramm, umfassend Befehle, die bewirken, dass das Steuergerät des Anspruchs 8 die Schritte (1, 2, 3) des Verfahrens (1000) gemäß einem der Ansprüche 1 bis 7 ausführt und/oder ansteuert.

10. Maschinenlesbares Speichermedium, auf dem das Computerprogramm nach Anspruch 9 gespeichert ist.

11. Trägerelement (150) zum Aufnehmen einer Probenflüssigkeit (10), wobei das Trägerelement (150) die folgenden Merkmale aufweist:
- ein Trägersubstrat (100) mit einer hydrophilen Oberflächenbeschichtung (105) an einer Seitenwand von zumindest einer Ausnehmung (200) in dem Trägersubstrat (100); und
- eine auf dem Trägersubstrat (100) angeordnete Polymerschicht (101; 103) mit einer hydrophoben Oberflächenbeschaffenheit.

12. Trägermodul (500), das die folgenden Merkmale aufweist:
- ein Trägerelement (150) gemäß Anspruch 11 zum Aufnehmen einer Probenflüssigkeit (10); und
- ein mit dem Trägerelement (150) verbindbares oder verbundenes Deckelelement (160), das ausgebildet ist, um die Probenflüssigkeit (10) auf das Trägerelement (100) aufzubringen.

13. Verfahren (800) zum Verwenden eines Trägermoduls (500) gemäß Anspruch 12, wobei bei dem Verwenden des Trägermoduls (500) eine Probenflüssigkeit (10) in Kontakt mit dem Deckelelement (160) gebracht wird, und/oder wobei die Probenflüssigkeit (10) mit einer Oberfläche des Trägerelements (150) in Kontakt gebracht wird.

## Claims

1. Method (1000) for producing a carrier element (150) for receiving a sample liquid (10), having a polymer layer (103) arranged on the carrier substrate and having a hydrophobic surface character, wherein the method (1000) comprises the following steps:
- coating (1) a carrier substrate (100) with a light-sensitive polymer layer (101) to give a coated carrier substrate (100), more particularly wherein the carrier substrate (100) has a hydrophilic surface character;
- exposing (2) and developing the coated carrier substrate (100) to give a structured polymer layer (102); and
- fluorinating (3) the structured polymer layer (102) arranged on the carrier substrate (100), to produce the carrier element (150) for receiving the sample liquid (10), wherein the structured polymer layer (102) acquires a hydrophobic surface character by the fluorination step (3),
**characterized by** depositing a layer (105) after the fluorination step (3) to alter and/or cover a surface of the carrier substrate (100), such that a side wall of at least one recess (200) in the carrier substrate (100) is formed hydrophilically.

2. Method (1000) according to Claim 1, wherein, in the coating step (1), the carrier substrate (100) is coated, which is at least partially formed from a semiconductor material, more particularly a silicon-containing material.

3. Method (1000) according to either of the preceding claims, comprising a step (21) of structuring the carrier substrate (100) to give the at least one recess (200) in the carrier substrate (100).

4. Method (1000) according to Claim 3, wherein, in the structuring step (21), a passivation layer (201) is generated on at least one side wall of the at least one recess (200), and wherein, in the fluorination step (3), the passivation layer arranged on at least one side wall of the recess (200) is at least partially removed.

5. Method (1000) according to any of the preceding claims, wherein, in the coating step (1), a substrate having an oxide layer (106) and/or a carrier substrate (100) coated with an adhesion promoter layer (104) is used as the carrier substrate (100).

6. Method (1000) according to any of the preceding claims, comprising a step (001) of applying a further light-sensitive polymer layer (109), and comprising a step (002) of further exposing and developing the further polymer layer (109) to give a further structured polymer layer (110).

7. Method (1000) according to Claim 6, comprising a further step (003) of structuring after the step (002) of further exposing and developing, to give at least one further structuring (500), more particularly a structuring of an oxide layer (106) present on the carrier substrate (100).

8. Control device (900) configured to execute and/or actuate the steps (1, 2, 3) of the method (1000) according to any of the preceding claims in corresponding units (905, 910, 915).

9. Computer program comprising commands which cause the control device of Claim 8 to execute and/or actuate the steps (1, 2, 3) of the method (1000) according to any of Claims 1 to 7.

10. Machine-readable storage medium on which the computer program according to Claim 9 is stored.

11. Carrier element (150) for receiving a sample liquid (10), wherein the carrier element (150) has the following features:
- a carrier substrate (100) having a hydrophilic surface coating (105) on a side wall of at least one recess (200) in the carrier substrate (100); and
- a polymer layer (101; 103) which is arranged on the carrier substrate (100) and has a hydrophobic surface character.

12. Carrier module (500) having the following features:
- a carrier element (150) according to Claim 11 for receiving a sample liquid (10); and
- a cover element (160) which can be connected or is connected to the carrier element (150) and which is designed to apply the sample liquid (10) to the carrier element (100).

13. Method (800) for using a carrier module (500) according to Claim 12, wherein, on use of the carrier module (500), a sample liquid (10) is brought into contact with the cover element (160), and/or wherein the sample liquid (10) is brought into contact with a surface of the carrier element (150).

## Revendications

1. Procédé (1000) de fabrication d'un élément support (150) destiné à recevoir un liquide d'échantillon (10), comportant une couche polymère (103) disposée sur le substrat support et présentant un état de surface hydrophobe, dans lequel le procédé (1000) comprend les étapes suivantes :
- le revêtement (1) d'un substrat support (100) avec une couche polymère photosensible (101), afin d'obtenir un substrat support (100) revêtu, en particulier dans lequel le substrat support (100) présente un état de surface hydrophile ;
- l'exposition (2) et le développement du substrat support (100) revêtu, afin d'obtenir une couche polymère structurée (102) ; et
- la fluoration (3) de la couche polymère structurée (102) disposée sur le substrat support (100), afin de fabriquer l'élément support (150) destiné à recevoir le liquide d'échantillon (10), dans lequel la couche polymère structurée (102) acquiert un état de surface hydrophobe par l'étape (3) de fluoration,
**caractérisé par** le dépôt d'une couche (105) après l'étape (3) de fluoration, afin de modifier et/ou de recouvrir une surface du substrat support (100), de sorte qu'une paroi latérale d'au moins un évidement (200) dans le substrat support (100) soit réalisée de manière hydrophile.

2. Procédé (1000) selon la revendication 1, dans lequel, à l'étape (1) de revêtement, le substrat support (100) est revêtu, lequel est réalisé au moins partiellement en un matériau semi-conducteur, en particulier un matériau contenant du silicium.

3. Procédé (1000) selon l'une des revendications précédentes, comprenant une étape (21) de structuration du substrat support (100), afin d'obtenir l'au moins un évidement (200) dans le substrat support (100).

4. Procédé (1000) selon la revendication 3, dans lequel, à l'étape (21) de structuration, une couche de passivation (201) est produite sur au moins une paroi latérale de l'au moins un évidement (200), et dans lequel, à l'étape (3) de fluoration, la couche de passivation disposée sur au moins une paroi latérale de l'évidement (200) est au moins partiellement éliminée.

5. Procédé (1000) selon l'une des revendications précédentes, dans lequel, à l'étape (1) de revêtement, un substrat support (100) revêtu d'une couche d'oxyde (106) et/ou d'une couche de promoteur d'adhérence (104) est utilisé comme substrat support (100).

6. Procédé (1000) selon l'une des revendications précédentes, comprenant une étape (001) d'application d'une autre couche polymère photosensible (109), et comprenant une étape (002) d'exposition et de développement supplémentaires de l'autre couche polymère (109), afin d'obtenir une autre couche polymère structurée (110).

7. Procédé (1000) selon la revendication 6, comprenant une autre étape (003) de structuration après l'étape (002) d'exposition et de développement supplémentaires, afin d'obtenir au moins une autre structuration (500), en particulier une structuration d'une couche d'oxyde (106) présente sur le substrat support (100).

8. Appareil de commande (900) configuré pour exécuter et/ou commander les étapes (1, 2, 3) du procédé (1000) selon l'une des revendications précédentes dans des unités correspondantes (905, 910, 915).

9. Programme informatique comprenant des instructions qui amènent l'appareil de commande selon la revendication 8 à exécuter et/ou à commander les étapes (1, 2, 3) du procédé (1000) selon l'une des revendications 1 à 7.

10. Support de stockage lisible par machine, sur lequel est stocké le programme informatique selon la revendication 9.

11. Élément support (150) destiné à recevoir un liquide d'échantillon (10), dans lequel l'élément support (150) présente les caractéristiques suivantes :
- un substrat support (100) comportant un revêtement de surface hydrophile (105) sur une paroi latérale d'au moins un évidement (200) dans le substrat support (100) ; et
- une couche polymère (101; 103) disposée sur le substrat support (100) et présentant un état de surface hydrophobe.

12. Module support (500) présentant les caractéristiques suivantes :
- un élément support (150) selon la revendication 11 destiné à recevoir un liquide d'échantillon (10) ; et
- un élément de couvercle (160) pouvant être relié ou relié à l'élément support (150), configuré pour appliquer le liquide d'échantillon (10) sur l'élément support (100).

13. Procédé (800) d'utilisation d'un module support (500) selon la revendication 12, dans lequel, lors de l'utilisation du module support (500), un liquide d'échantillon (10) est mis en contact avec l'élément de couvercle (160), et/ou dans lequel le liquide d'échantillon (10) est mis en contact avec une surface de l'élément support (150).
